# EUROPEAN PATENT APPLICATION

(11) **EP 1 727 396 A1**
(43) Date of publication of application: **29.11.2006**
(21) Application number: 05720495.0
(22) Date of filing: 10.03.2005
(51) Int. Cl.: H05B 33/12, H05B 33/14

(54) **ORGANIC ELECTROLUMINESCENT DEVICE**

(30) Priority: 19.03.2004 JP 2004081156
(71) Applicant: IDEMITSU KOSAN CO., LTD., Tokyo 100-8321 (JP)
(72) Inventor: ITO, Mitsunori, 2990293 (JP); MATSUURA, Masahide, 2990293 (JP); YAMAMOTO, Hiroshi, 2990293 (JP); KAWAMURA, Hisayuki, 2990293 (JP); HOSOKAWA, Chishio, 2990293 (JP)
(74) Representative: Gille Hrabal Struck Neidlein Prop Roos
(86) International application number: PCT/JP2005/004224
(87) International publication number: WO 2005/091684

(57) **Abstract**

An organic EL device which can easily control colors to obtain white light emission, and has a high efficiency. An organic electroluminescent device 10 including; at least an anode 1, an organic emitting layer and a cathode 6 stacked in this order; at least a first emitting layer 3 including a fluorescent dopant and a second emitting layer 4 comprising a phosphorescent dopant being stacked in the organic emitting layer.

## Description

### Technical Field

The invention relates to an organic electroluminescent device. In more detail, the invention relates to an organic electroluminescent device comprising two emitting layers suitable for white emission.

### Technical Background

Recently, white organic electroluminescent (EL) devices are being actively developed because they can be used for a mono-color display device, a lighting apparatus such as a back light, and a full-color display with color filters.
Chromaticity change in the white organic EL device not only impairs the quality of the product, but also causes decrease of color reproducibility in, for instance, a full-color display which is combined with color filters. Therefore, minimal chromaticity change is required for the white organic EL devices.

Many methods of producing white light emission by an organic EL device have been disclosed. Few of the methods produce white light with only one kind of emitting material and a single organic EL device generally uses two or more kinds of emitting materials that emit light simultaneously.

In the case of using three kinds of emitting materials, a combination of red, blue and green lights corresponding to three primary colors gives white light. However, there are problems that such organic EL devices have difficulty controlling chromaticity and that they are poor in reproducibility.
In the case of using two kinds of emitting materials, a blue emitting material and a yellow-to-orange or red emitting material, yellow-to-orange or red being the complementary color to blue, are selected. However, the yellow-to-orange or red light emission becomes strong in many cases, thereby changing chromaticity.

For instance, as shown in reference examples 1 and 2 of JP-2001-A-52870, blue emission tends to be lowered in conventional white organic EL devices and they have problem in the point of chromaticity change. Further, a blue dopant and a yellow-to-orange or red dopant are used together and the doping ratio thereof can be adjusted to give white light emission. However, in addition to the tendency for red to become strong, energy is liable to transfer from blue to red so as to give reddish white light. Therefore, in order to obtain white light, a yellow-to-orange red dopant has to be used in a considerably diluted manner, so that there is a problem in the point of reproducibility.

In another method, a hole-transporting layer adjacent to an emitting layer is doped with a yellow-to-orange or red dopant. In this method, electrons are not easily injected into the hole-transporting layer so that even when doping with a yellow-to-orange or red emitting material toward which the light emission tends to shift is conducted, strong red light emission does not occur. Thus, this method has advantages in that it is easy to balance the blue light emission and the yellow-to-orange or red light emission in order to obtain white light emission and that the resultant organic EL device is excellent in luminous efficiency and has a long lifetime. However, in view of the problem that energy transmission depends upon distance, there has been a critical issue that extensive chromaticity change is observed after the organic EL device has been driven continuously or it has been kept under a high temperature condition.

It is the inventors' understanding that the balance of electrons and holes breaks down with degeneration because excited red emitting molecules concentrate at the interface on the hole-transporting layer side, and even if the extent of the concentration to the interface changes slightly, red light emission changes significantly while blue light emission does not change much. This is the cause of chromaticity change.

Further, there is a stacked type organic EL device which has two emitting layers and in which the emitting layer at the anode side is a yellow-to-orange or red emitting layer and the one at the cathode side is a blue emitting layer. Although this type is excellent in efficiency, it requires to suppress the yellow to orange or red light emission in order to obtain white light emission. For this, it is necessary for the thickness of the yellow-to-orange or red emitting layer to be made thinner than that of the blue emitting layer, or for the doping concentration of the yellow-to-orange or red emitting material to be lowered, so that fabrication of such a device is difficult. Concretely, unless the thickness of the yellow-to-orange or red emitting layer is made approximately 1 to 2 nm, white light emission cannot be obtained in many cases. Such a thickness is almost the same as the size of the molecules of ordinary low molecular type organic EL materials, and it is very difficult to control the thickness to this value.

On the other hand, by making the emitting layer on the anode side, toward which color range of the emitted light is liable to shift, a blue emitting layer, the tendency of the emitted light color to shift to red is counteracted, white light emission can be obtained and chromaticity change during driving is less, even when the yellow-to-orange or red emitting layer is given a thickness of approximately 10 to 30 nm.
However, in view of practical use, a stable white organic EL device is desired whose chromaticity change is even smaller.

The invention was achieved in view of the above-described problems. An object of the invention is to provide an organic EL device which can easily control colors to obtain white light emission, and has a high luminous efficiency.

### Disclosure of the Invention

Though research for solving the foregoing subjects, the inventors found that, in a device comprising two emitting layers provided between an anode and a cathode, colors can be easily adjusted by forming both a fluorescent emitting layer and a phosphorescent emitting layer, and completed the invention.

The invention provides the following organic EL device and display.
1. An organic electroluminescent device comprising; at least an anode, an organic emitting layer and a cathode stacked in this order; at least a first emitting layer comprising a fluorescent dopant and a second emitting layer comprising a phosphorescent dopant being stacked in the organic emitting layer.
2. The organic electroluminescence device according to 1,
   wherein the first emitting layer is closer to the anode than the second emitting layer.
3. The organic electroluminescent device according to 1,
wherein the first emitting layer is closer to the cathode than the second emitting layer.

4. The organic electroluminescent device according to any one of 1 to 3, wherein a host of the first emitting layer comprises an electron transporting compound or hole transporting compound, and a host of the second emitting layer comprises an electron transporting compound or hole transporting compound.
5. The organic electroluminescent device according to 4,
   wherein the electron mobility of the electron transporting compound is 10⁻⁵ cm²/V·s or more.
6. The organic electroluminescent device according to 4,
wherein the hole mobility of the hole transporting compound is 10⁻⁴ cm²/V·s or more.

7. The organic electroluminescent device according to any one of 1 to 6, wherein the first emitting layer emits blue light, or yellow-to-orange or red light.
8. The organic electroluminescent device according to any one of 1 to 7, wherein the second emitting layer emits blue light, or yellow-to-orange or red light.
9. The organic electroluminescent device according to any one of 1 to 8 which emits white light.
10. A display comprising the organic electroluminescent device according to any one of 1 to 9.

According to the invention, in a device comprising two emitting layers provided between an anode and a cathode, an organic EL device which easily adjusts colors and has a high luminous efficiency can be provided by utilizing both of fluorescent emission and phosphorescent emission.

### Brief Description of Drawings

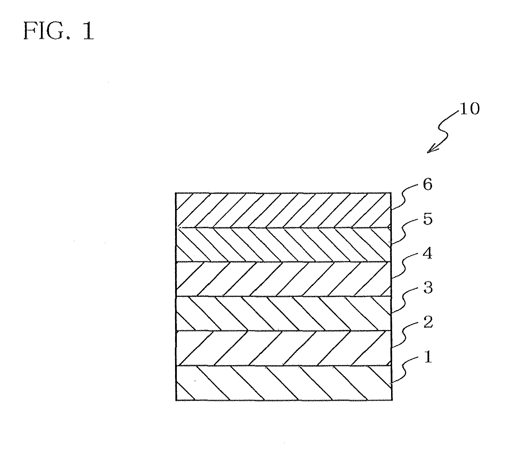

Fig. 1 is a diagram showing one embodiment of the organic EL device of the invention.

### Preferred Embodiments of the Invention

Fig. 1 is a view showing an embodiment of the organic EL device of the invention.
An organic EL device 10 has a structure where an anode 1, a first organic layer 2, organic emitting layers (first emitting layer 3 and second emitting layer 4), a second organic layer 5 and a cathode 6 are stacked in this order on a substrate (not shown).
The organic EL device 10 emits white light by stacking a blue emitting layer as the first emitting layer 3 and a yellow-to-orange or red emitting layer as the second emitting layer 4.

The first emitting layer 3 is an emitting layer containing a fluorescent dopant and emits florescent light. The second emitting layer 4 is an emitting layer containing a phosphorescent dopant and emits phosphorescent light.
Blue emission, and yellow-to-orange or red emission can be easily balanced by stacking a fluorescent emitting layer and phosphorescent emitting layer, which balance is necessary for white emission. Consequently it is not required that the thickness of either one of emitting layers is extremely thin, or the concentration of a dopant therein is extremely low. Thus the two emitting layers can efficiently and stably emit light, whereby the device can emit white light at a high efficiency and the tinge thereof can be easily adjusted.
The organic EL device of the invention is not limited to white emission, but is particularly suitable for white-emission type organic EL device.

The first organic layer 2 is a hole-injecting layer, hole-transporting layer, organic semiconductive layer or the like. The second organic layer 5 is an electron-transporting layer, electron-injecting layer or the like.
The structure examples of the organic EL device of the invention are shown below. In order to obtain an organic EL device emitting white light, if the first emitting layer is a blue emitting layer, the second emitting layer is a yellow-to-orange or red emitting layer; and if the first emitting layer is a yellow-to-orange or red emitting layer, the second emitting layer is a blue emitting layer.

a. Anode/first emitting layer/second emitting layer/cathode
b. Anode/second emitting layer/first emitting layer/cathode
c. Anode/hole transporting layer/first emitting layer/second emitting layer/cathode
d. Anode/hole transporting layer/second emitting layer/first emitting layer/cathode
e. Anode/hole transporting layer/first emitting layer/second emitting layer/electron transporting layer/cathode
f. Anode/hole transporting layer/second emitting layer/first emitting layer/electron transporting layer/cathode
g. Anode/hole injecting layer/hole transporting layer/first emitting layer/second emitting layer/electron transporting layer/cathode
h. Anode/hole injecting layer/hole transporting layer/second emitting layer/first emitting layer/electron transporting layer/cathode
i. Anode/hole injecting layer/hole transporting layer/first emitting layer/second emitting layer/electron transporting layer/electron injecting layer/cathode,
j. Anode/hole injecting layer/hole transporting layer/second emitting layer/first emitting layer/electron transporting layer/electron injecting layer/cathode

### Among these, i and j are preferred.

The structure other than the first emitting layer (emitting layer containing a fluorescent dopant) and the second emitting layer (emitting layer containing a phosphorescent dopant) are not particularly limited so long as the first and second layers are stacked. For example, an emitting layer may be made of three or more layers. A charge barrier layer and the like may be interposed between emitting layers.
The first and second emitting layers will be described below, which layers are features of the invention. The structures and production methods of the other members, e.g., an organic layer, inorganic compound layer, anode and cathode, will be briefly described since they may have general structures.

### 1. First emitting layer

The first emitting layer comprises a host material and a fluorescent dopant.
Examples of the host material include a styryl derivatives, arylene derivatives or aromatic amine derivatives, and 8-hydroxyquinoline and its derivatives.
The styryl derivatives are preferably distyryl derivatives, tristyryl derivatives, tetrastyryl derivatives and styrylamine derivatives.
The arylene derivatives are preferably anthracene derivatives, especially compounds that contain an arylanthracene skeleton.

The styryl and anthracene derivatives include compounds represented by the following formulas [1] to [6].

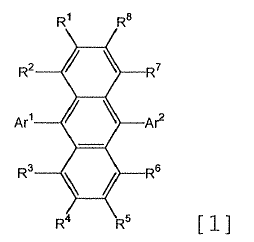

wherein R¹ to R⁸ are independently a hydrogen atom, a halogen atom, a cyano group, a nitro group, a substituted or unsubstituted alkyl group with 1 to 20 carbon atoms, a substituted or unsubstituted alkoxy group with 1 to 20 carbon atoms, a substituted or unsubstituted aryloxy group with 6 to 30 carbon atoms, a substituted or unsubstituted alkylthio group with 1 to 20 carbon atoms, a substituted or unsubstituted arylthio group with 6 to 30 carbon atoms, a substituted or unsubstituted arylalkyl group with 7 to 30 carbon atoms, an unsubstituted monocyclic group with 5 to 30 carbon atoms, a substituted or unsubstituted condensed polycyclic group with 10 to 30 carbon atoms or a substituted or unsubstituted hetrocyclic group with 5 to 30 carbon atoms; and Ar¹ and Ar² are independently a substituted or unsubstituted aryl group with 6 to 30 carbon atoms or a substituted or unsubstituted alkenyl group, and a substituent is a substituted or unsubstituted alkyl group with 1 to 20 carbon atoms, a substituted or unsubstituted alkoxy group with 1 to 20 carbon atoms, a substituted or unsubstituted aryloxy group with 6 to 30 carbon atoms, a substituted or unsubstituted alkylthio group with 1 to 20 carbon atoms, a substituted or unsubstituted arylthio group with 6 to 30 carbon atoms, a substituted or unsubstituted arylalkyl group with 6 to 30 carbon atoms, an unsubstituted monocyclic group with 5 to 30 carbon atoms, a substituted or unsubstituted condensed polycyclic group with 10 to 30 carbon atoms or a substituted or unsubstituted heterocyclic group with 5 to 30 carbon atoms.

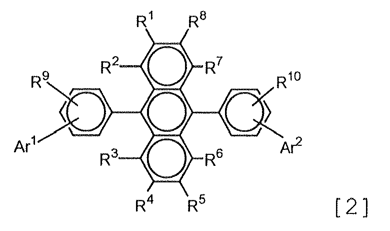

wherein R¹ to R¹⁰ are independently a hydrogen atom, a halogen atom, a cyano group, a nitro group, a substituted or unsubstituted alkyl group with 1 to 20 carbon atoms, a substituted or unsubstituted alkoxy group with 1 to 20 carbon atoms, a substituted or unsubstituted aryloxy group with 6 to 30 carbon atoms, a substituted or unsubstituted alkylthio group with 1 to 20 carbon atoms, a substituted or unsubstituted arylthio group with 6 to 30 carbon atoms, a substituted or unsubstituted arylalkyl group with 7 to 30 carbon atoms, an unsubstituted monocyclic group with 5 to 30 carbon atoms, a substituted or unsubstituted condensed polycyclic group with 10 to 30 carbon atoms or a substituted or unsubstituted hetrocyclic group with 5 to 30 carbon atoms; and Ar¹ and Ar² are independently a substituted or unsubstituted aryl group with 6 to 30 carbon atoms or a substituted or unsubstituted alkenyl group, and a substituent is a substituted or unsubstituted alkyl group with 1 to 20 carbon atoms, a substituted or unsubstituted alkoxy group with 1 to 20 carbon atoms, a substituted or unsubstituted aryloxy group with 6 to 30 carbon atoms, a substituted or unsubstituted alkylthio group with 1 to 20 carbon atoms, a substituted or unsubstituted arylthio group with 6 to 30 carbon atoms, a substituted or unsubstituted arylalkyl group with 6 to 30 carbon atoms, an unsubstituted monocyclic group with 5 to 30 carbon atoms, a substituted or unsubstituted condensed polycyclic group with 10 to 30 carbon atoms or a substituted or unsubstituted heterocyclic group with 5 to 30 carbon atoms.

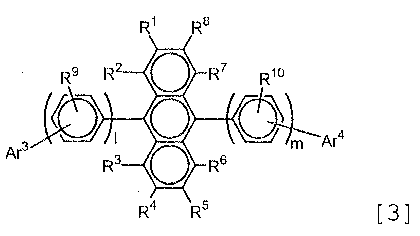

wherein R¹ to R¹⁰ are independently a hydrogen atom, a halogen atom, a cyano group, a nitro group, a substituted or unsubstituted alkyl group with 1 to 20 carbon atoms, a substituted or unsubstituted alkoxy group with 1 to 20 carbon atoms, a substituted or unsubstituted aryloxy group with 6 to 30 carbon atoms, a substituted or unsubstituted alkylthio group with 1 to 20 carbon atoms, a substituted or unsubstituted arylthio group with 6 to 30 carbon atoms, a substituted or unsubstituted arylalkyl group with 7 to 30 carbon atoms, an unsubstituted monocyclic group with 5 to 30 carbon atoms, a substituted or unsubstituted condensed polycyclic group with 10 to 30 carbon atoms or a substituted or unsubstituted hetrocyclic group with 5 to 30 carbon atoms; and Ar³ and Ar⁴ are independently a substituted or unsubstituted aryl group with 6 to 30 carbon atoms or a substituted or unsubstituted alkenyl group, and a substituent is a substituted or unsubstituted alkyl group with 1 to 20 carbon atoms, a substituted or unsubstituted alkoxy group with 1 to 20 carbon atoms, a substituted or unsubstituted aryloxy group with 6 to 30 carbon atoms, a substituted or unsubstituted alkylthio group with 1 to 20 carbon atoms, a substituted or unsubstituted arylthio group with 6 to 30 carbon atoms, a substituted or unsubstituted arylalkyl group with 6 to 30 carbon atoms, an unsubstituted monocyclic group with 5 to 30 carbon atoms, a substituted or unsubstituted condensed polycyclic group with 10 to 30 carbon atoms, a substituted or unsubstituted heterocyclic group with 5 to 30 carbon atoms or a substituted or unsubstituted alkenyl group with 4 to 40 carbon atoms. 1 is 1 to 3, m is 1 to 3 and 1+m is 2 or more.

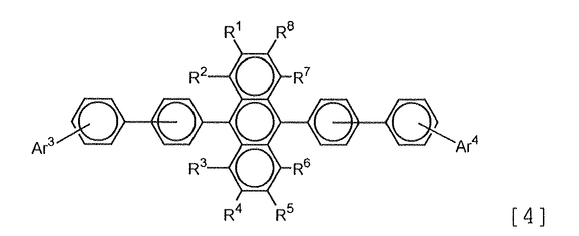

wherein R¹ to R⁸ are independently a hydrogen atom, a halogen atom, a cyano group, a nitro group, a substituted or unsubstituted alkyl group with 1 to 20 carbon atoms, a substituted or unsubstituted alkoxy group with 1 to 20 carbon atoms, a substituted or unsubstituted aryloxy group with 6 to 30 carbon atoms, a substituted or unsubstituted alkylthio group with 1 to 20 carbon atoms, a substituted or unsubstituted arylthio group with 6 to 30 carbon atoms, a substituted or unsubstituted arylalkyl group with 7 to 30 carbon atoms, an unsubstituted monocyclic group with 5 to 30 carbon atoms, a substituted or unsubstituted condensed polycyclic group with 10 to 30 carbon atoms or a substituted or unsubstituted hetrocyclic group with 5 to 30 carbon atoms; and Ar³ and Ar⁴ are independently a substituted or unsubstituted aryl group with 6 to 30 carbon atoms or a substituted or unsubstituted alkenyl group, and a substituent is a substituted or unsubstituted alkyl group with 1 to 20 carbon atoms, a substituted or unsubstituted alkoxy group with 1 to 20 carbon atoms, a substituted or unsubstituted aryloxy group with 6 to 30 carbon atoms, a substituted or unsubstituted alkylthio group with 1 to 20 carbon atoms, a substituted or unsubstituted arylthio group with 6 to 30 carbon atoms, a substituted or unsubstituted arylalkyl group with 6 to 30 carbon atoms, an unsubstituted monocyclic group with 5 to 30 carbon atoms, a substituted or unsubstituted condensed polycyclic group with 10 to 30 carbon atoms, a substituted or unsubstituted heterocyclic group with 5 to 30 carbon atoms or a substituted or unsubstituted alkenyl group with 4 to 40 carbon atoms.

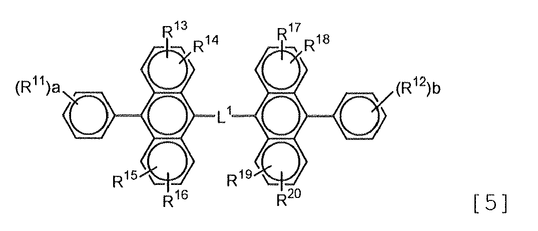

wherein R¹¹ to R²⁰ are independently a hydrogen atom, an alkenyl group, an alkyl group, a cycloalkyl group, an aryl group, an alkoxy group, an aryloxy group, an alkylamino group, an arylamino group or a substituted or unsubstituted heterocyclic group; a and b are each an integer of 1 to 5; when they are 2 or more, R¹¹s or R¹²s may be the same or different, or R¹¹s or R¹²s may be bonded together to form a ring; R¹³ and R¹⁴, R¹⁵ and R¹⁶, R¹⁷ and R¹⁸, or R¹⁹ and R²⁰ may be bonded together to form a ring; and L¹ is a single bond, -O-, -S-, -N(R)- (R is an alkyl group or a substituted or unsubstituted aryl group) or an arylene group.

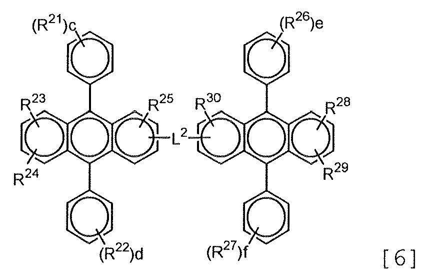

wherein R²¹ to R³⁰ are independently a hydrogen atom, an alkenyl group, an alkyl group, a cycloalkyl group, an aryl group, an alkoxy group, an aryloxy group, an alkylamino group, an arylamino group or a substituted or unsubstituted heterocyclic group; c, d, e and f are each an integer of 1 to 5; when they are 2 or more, R²¹s, R²²s, R²⁶s or R²⁷s may be the same or different, R²¹s, R²²s, R²⁶s or R²⁷s may be bonded together to form a ring, or R²³ and R²⁴, or R²⁸ and R²⁹ may be bonded together to form a ring; and L² is a single bond, -O-, -S-, -N(R)- (R is an alkyl group or a substituted or unsubstituted aryl group) or an arylene group.

The aromatic amine derivatives are preferably a compound containing 2 to 4 nitrogen atoms substituted with an aromatic group, more preferably further containing at least one alkenyl group.
The aromatic amines include compounds represented by the following formulas [7] to [8].

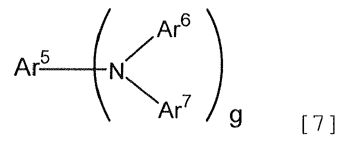

wherein Ar⁵, Ar⁶ and Ar⁷ are independently a substituted or unsubstituted monovalent aromatic group with 6 to 40 carbon atoms and g is an integer of 1 to 4.

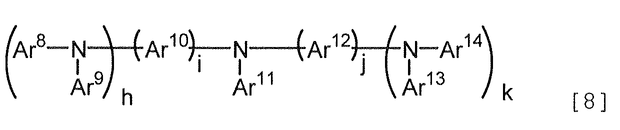

wherein Ar⁸, Ar⁹, Ar¹¹, Ar¹³ and Ar¹⁴ are independently a substituted or unsubstituted monovalent aromatic group with 6 to 40 carbon atoms or styryl group, Ar¹⁰ and Ar¹² are independently a substituted or unsubstituted divalent aromatic group with 6 to 40 carbon atoms or styryl group, h and k are each an integer of 0 to 2 and i and j are each an integer of 0 to 3.

As an example of the metal complexes of 8-hydroxyquinoline or its derivatives, metal chelate oxynoide compounds including chelates of oxine (generally 8-quinolinol or 8-hydroxyquinoline), such as tris(8-quinolinol)aluminum, can be used.

When a compound with an electron-transporting property such as anthracene derivatives and 8-hydroxyquinoline and its derivatives is used as a host material, host materials for a blue emitting layer and a yellow-to-red emitting layer may be the same or different.
When a compound with a hole transporting property such as styryl derivatives and aromatic amines is used as a host material, it is preferable that host materials for a blue emitting layer and a yellow-to-red emitting layer are different from each other.

The above-mentioned host compounds can be used individually or as a combination of two or more kinds.

A blue dopant is preferably at least one selected from styrylamines, amine-substituted styryl compounds and compounds containing fused aromatic rings. A blue dopant may comprise multiple kinds of compounds.
Examples of the styryl amines and amine-substituted styryl compounds include compounds represented by the general formulas [9] to [10].

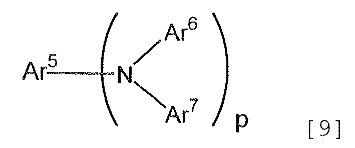

wherein Ar⁵, Ar⁶, and Ar⁷ are independently a substituted or unsubstituted aromatic group with 6 to 40 carbon atoms or styryl group, and p is an integer of 1 to 3.

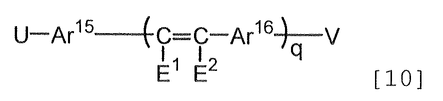

wherein Ar¹⁵ and Ar¹⁶ are independently an arylene group with 6 to 30 carbon atoms; E¹ and E² are independently an aryl or alkyl group with 6 to 30 carbon atoms, a hydrogen atom, or a cyano group; q is an integer of 1 to 3; U and/or V are a substituent including an amino group and the amino group is preferably an arylamino group.

Examples of the above-mentioned compounds containing fused aromatic rings are compounds represented by the general formula [11].

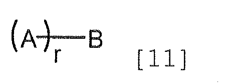

wherein A is an alkyl group or an alkoxy group with 1 to 16 carbon atoms, a substituted or unsubstituted aryl group with 6 to 30 carbon atoms, a substituted or unsubstituted alkylamino group with 6 to 30 carbon atoms, a substituted or unsubstituted arylamino group with 6 to 30 carbon atoms and B is a fused aromatic ring group with 10 to 40 carbon atoms; and r is an integer of 1 to 4.

There can be used as a yellow-to-orange or red dopant florescent compounds containing at least one of a fluoranthene skeleton and a perylene skeleton. Examples thereof include compounds represented by the following general formulas [12] to [28].

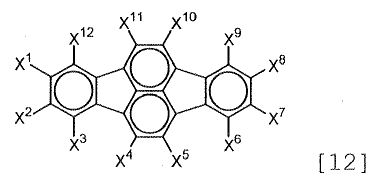

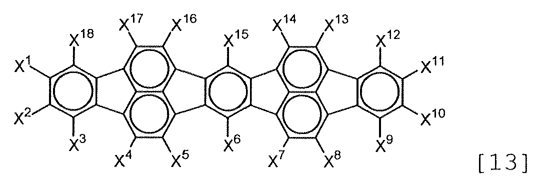

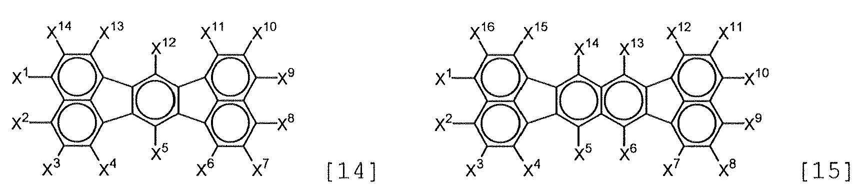

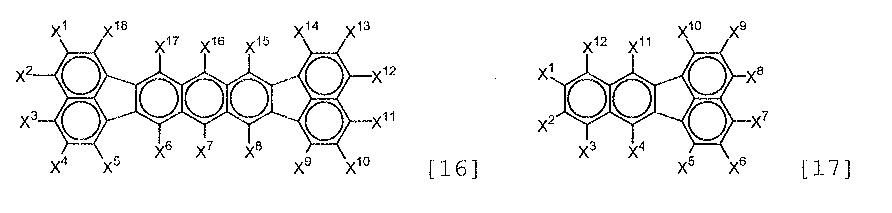

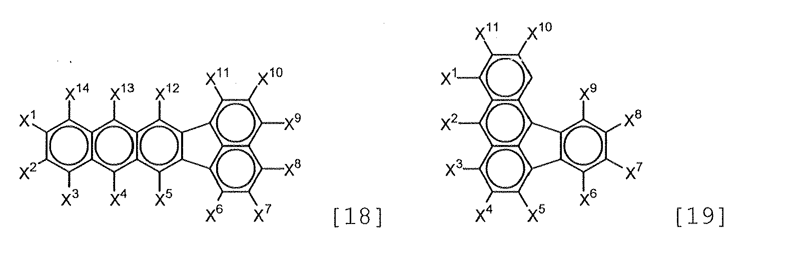

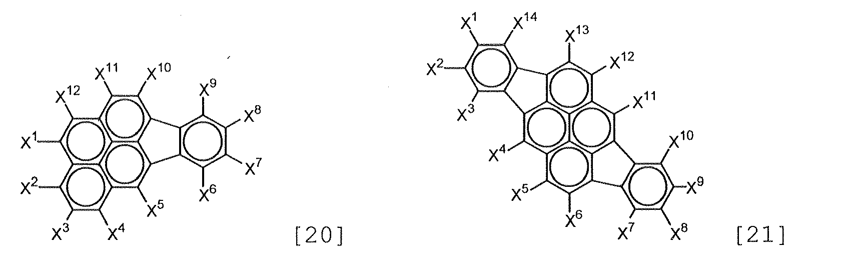

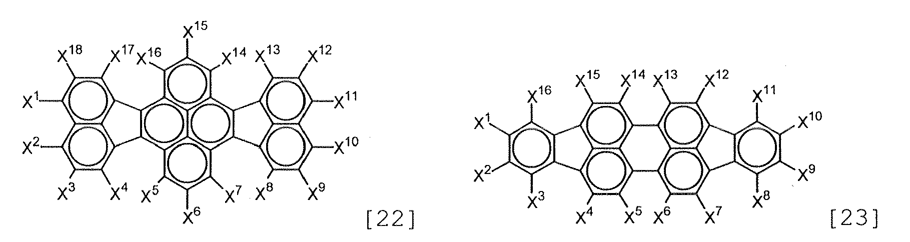

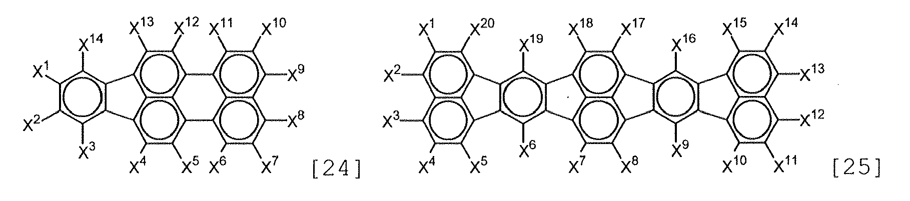

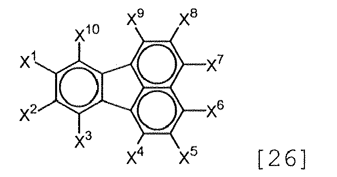

wherein X¹ to X²⁰ are independently a hydrogen atom, a linear, branched or cyclic alkyl group with 1 to 20 carbon atoms, a linear, branched or cyclic alkoxy group with 1 to 20 carbon atoms, a substituted or unsubstituted aryl group with 6 to 30 carbon atoms, a substituted or unsubstituted aryloxy group with 6 to 30 carbon atoms, a substituted or unsubstituted arylamino group with 6 to 30 carbon atoms, a substituted or unsubstituted alkylamino group with 1 to 30 carbon atoms, a substituted or unsubstituted arylalkylamino group with 7 to 30 carbon atoms or a substituted or unsubstituted alkenyl group with 8 to 30 carbon atoms; adjacent substituents and X¹ to X²⁰ may be bonded together to form a ring structure; and when adjacent substituents are an aryl group, the substituents may be the same.
The compounds represented by the general formulas [12] to [26] preferably contain an amino group or an alkenyl group.

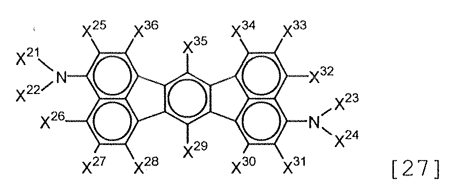

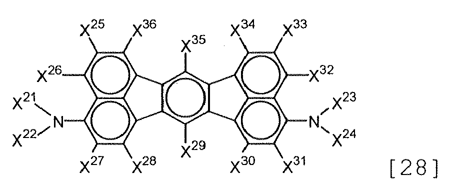

wherein X²¹ to X²⁴ are independently an alkyl group with 1 to 20 carbon atoms, a substituted or unsubstituted aryl group with 6 to 30 carbon atoms; X²¹ and X²² and/or X²³ and X²⁴ may be bonded to each other with a carbon to carbon bond, -O- or -S- therebetween; X²⁵ to X³⁶ are independently a hydrogen atom, a linear, branched or cyclic alkyl group with 1 to 20 carbon atoms, a linear, branched or cyclic alkoxy group with 1 to 20 carbon atoms, a substituted or unsubstituted aryl group with 6 to 30 carbon atoms, a substituted or unsubstituted aryloxy group with 6 to 30 carbon atoms, a substituted or unsubstituted arylamino group with 6 to 30 carbon atoms, a substituted or unsubstituted alkylamino group with 1 to 30 carbon atoms, a substituted or unsubstituted arylalkylamino group with 7 to 30 carbon atoms or a substituted or unsubstituted alkenyl group with 8 to 30 carbon atoms; adjacent substituents and X²⁵ to X³⁶ may be bonded together to form a ring structure; and at least one of the substituents X²⁵ to X³⁶ in each of the formulas preferably contain an amino or alkenyl group.

A florescent compound containing a fluoranthene skeleton preferably contains an electron-donating group for high efficiency and long lifetime. A preferable electron-donating group is a substituted or unsubstituted arylamino group. A fluorescent compound containing a fluoranthene skeleton preferably has 5 or more fused rings, more preferably 6 or more fused rings, for the following reason. The fluorescent compound has a fluorescent peak wavelength of 540 to 700 nm. The emission from a blue emitting material and emission from the fluorescent compound overlap to give a white color. The above-mentioned fluorescent compound preferably contains a plurality of fluoranthene skeletons since the emitted light color falls in the yellow-to-orange or red zone. Particularly preferred fluorescent compound contains an electron-donating group, and a fluoranthene or perylene skeleton, and has a fluorescent peak wavelength of 540 to 700 nm.

The content of a fluorescent dopant in an emitting layer is not limited and can be properly selected according to purposes; for example, it is 0.1 to 70 mass %, preferably 1 to 30 mass %.

### 2. Second emitting layer

The second emitting layer comprises a host material and a phosphorescent dopant.
A host suitable for phosphorescent emission is a compound which allows a phosphorescent compound to emit as a result of energy transfer from its excited state to the phosphorescent dopant. A host compound is not limited so long as the compound can transfer exciton energy to a phosphorescent compound and it can be selected depending on purposes.
As the compound, a compound having at least one partial structure selected from a heterocyclic group and a carbazolyl group in the molecule thereof can be preferably used.

Examples of the host compounds include carbazole, triazole, oxazole, oxadiazole, imidazole, polyarylalkane, pyrazoline, pyrazolone, phenylanediamine, arylamine, amino-substituted calcone, styryl anthracene, fluorenone, hydrazone, stilbene and silazane derivatives; aromatic tertiary amine, styrylamine, aromatic dimethylidene and porphyrin compounds; anthraquinodimethane, anthrone, diphenylquinone, thiopyrandioxide, carbodiimide, fluoreniridenemethane and distyrylpyrazine derivatives; hetrocyclic tetracarboxylic anhydrides such as naphthaleneperylene; phthalocyanine derivatives; metal complexes of 8-quinolinol derivatives, various metal complex polysilane compounds represented by metal complexes having metalphthalocyanine, benzoxazole or benzothiaole as a ligand; electroconductive high molecular oligomers such as poly(N-vinylcarbazole) derivatives, aniline copolymers, thiophene oligomers and polythiophene; and polymer compounds such as polythiophene, polyphenylene, polyphenylenevinylene and polyfluorene derivatives.
Host compounds can be used individually or as a combination of two or more kinds.

Specific examples of the compound having at least one partial structure selected from a heterocyclic group and a carbazolyl group in the molecule thereof are shown below. The materials of the invention are not limited to the compounds shown below.

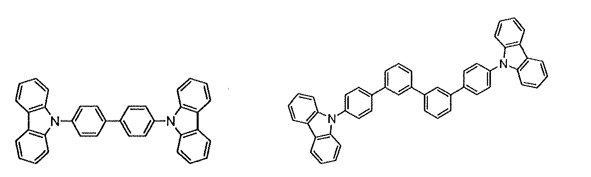

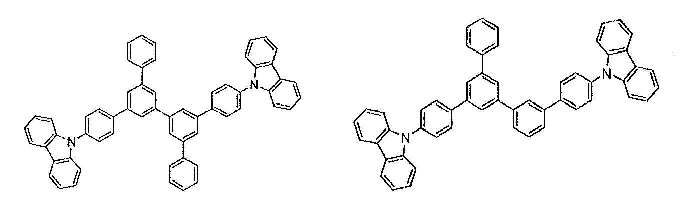

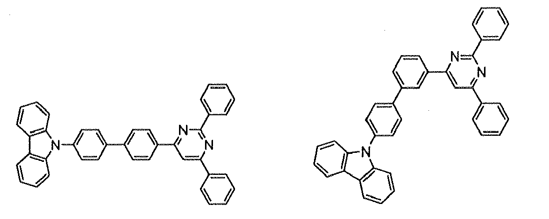

A phosphorescent dopant is a compound that can emit light from triplet excitons. The dopant is not limited as long as it can emit light from triplet excitons, but it is preferably a metal complex containing at least one metal selected from the group of Ir, Ru, Pd, Pt, Os and Re. A porphyrin metal complex or an ortho-metalated metal complex is preferable. As a porphyrin metal complex, a porphyrin platinum complex is preferable.
The phosphorescent dopants can be used individually or as a combination of two or more kinds.

There are various ligands forming an ortho-metalated metal complex. Preferable ligands include 2-phenylpyridine, 7,8-benzoquinoline, 2-(2-thienyl)pyridine, 2-(1-naphtyl)pyridine and 2-phenylquinoline derivatives.
These derivatives can contain substituents if necessary. As an auxiliary ligand, ligands such as acetylacetonate and picric acid, other than the above ligands, may be contained.

Fluorides such as a trifluoromethyl group are preferably introduced into the above metal complex ligand as a phosphorescent blue dopant.

Preferred are 2-phenylquinoline derivatives, 2-(2-thienyl)pyridine derivatives and the like as a phosphorescent yellow-to-orange or red dopant.

The content of a phosphorescent dopant in an emitting layer can be properly selected according to purposes without limitation; it is preferably 0.1 to 70 mass %, more preferably 1 to 30 mass %. When the content of a phosphorescent compound is less than 0.1 mass %, the resulting emission is weak and the effect of containing a phosphorescent dopant cannot be sufficiently obtained.
When the content exceeds 70 mass %, the phenomenon called concentration quenching may significantly proceed, thereby degrading the device performance.

In the case where the first emitting layer or second emitting layer emits blue light, the blue dopant preferably has a maximum peak wavelength of 400 nm to 500 nm.
In the case where the first emitting layer or second emitting layer emits yellow-to-orange or red light, the yellow-to-orange or red dopant preferably has a maximum peak wavelength of 540 nm to 700 nm.

In addition to the above-mentioned host materials and the dopants, the first emitting layer and second emitting layer may contain hole transporting materials, electron transporting materials and polymer binders if necessary.

The thickness of each of the first emitting layer and the second emitting layer is preferably adjusted depending on the emission color as follows.
The thickness of a blue emitting layer is preferably 5 to 30 nm, more preferably 7 to 30 nm and most preferably 10 to 30 nm. When it is less than 5 nm, the formation of an emitting layer and the adjustment of chromaticity may become difficult. When it exceeds 30 nm, the driving voltage may increase.
The thickness of a yellow-to-orange or red emitting layer is preferably 5 to 100 nm, more preferably 10 to 50 nm. When it is less than 5 nm, the luminous efficiency may decrease. When it exceeds 100 nm, the driving voltage may increase.

Any one of the first emitting layer and the second emitting layer may be formed on the anode side. The anode-side emitting layer is preferably a blue emitting layer.

The host materials of the first emitting layer and the second emitting layer are preferably electron transporting compounds and/or hole transporting compounds. This facilitates adjustment of the emission chromaticity and enhances the luminous efficiency.

In particular, it is preferable that the host material of the first emitting layer is an electron transporting compound and the host material of the second emitting layer is an hole transporting compound for enhancing chromaticity and luminous efficiency.

The electron transporting compound is a compound having a large electron mobility. The electron mobility is preferably 10⁻⁵ cm²/V·s or more. Specific examples thereof include the above-mentioned metal complexes of anthracene derivatives, 8-hydroxyquinoline and its derivatives.
On the other hand, the hole transporting compound is a compound having a large hole mobility. The hole mobility is preferably 10⁻⁴ cm²/V·s or more. Specific examples include the above-mentioned styryl derivatives and aromatic amines.

The electron mobility and the hole mobility can be measured by the Time of Flight method or the like. The measurement of electron mobility by the Time of Flight method can be conducted with TOF-301 manufactured by Kabushiki Kaisha Optel or the like.

### 3. Other constituent members

### (1) First organic layer

A hole-injecting layer, a hole-transporting layer, an organic semiconductor layer and the like can be arranged between the anode and the first emitting layer as a first organic layer. The hole-injecting layer or the hole-transporting layer is a layer for helping the injection of holes into the emitting layer so as to transport holes to an emitting region. The hole mobility thereof is large and the ionization energy thereof is usually as small as 5.5 eV or less. A hole-injecting layer is formed to control energy level, for example, to reduce rapid energy level changes. Such a hole-injecting or hole-transporting layer is preferably made of a material which can transport holes to the emitting layer at a low electric field intensity. The hole mobility thereof is preferably at least 10⁻⁶ cm²/V· s when an electric field of, e.g., 10⁴ to 10⁶ V/cm is applied.

The material for forming the hole-injecting layer or the hole-transporting layer is not particularly limited so long as it has the above desirable properties. It can be arbitrarily selected from materials which have been widely used as a material transporting electric charge of holes in photoconductive materials and known materials used in a hole-injecting layer of organic EL devices.

Specific examples of materials for a hole-injecting layer and a hole-transporting layer, include triazole derivatives (see USP No. 3,112,197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3,526,501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 55-85495, 57-11350, 57-148749 and 2-311591, and others), stilbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive high molecular oligomers (in particular thiophene oligomers) disclosed in JP-A-1-211399.

In addition to the above-mentioned substances, the following can also be used: porphyrin compounds (disclosed in JP-A-63-2956965 and others), aromatic tertiary amine compounds and styrylamine compounds (see USP No. 4,127,412, JP-A-53-27033, 54-58445, 54-149634, 54-64299, 55-79450, 55-144250, 56-119132, 61-295558, 61-98353 and 63-295695, and others), and aromatic tertiary amine compounds. The following can also be given as examples: 4,4'-bis(N-(1-naphthyl)-N-phenylamino)biphenyl, which has in the molecule thereof two condensed aromatic rings, disclosed in USP No. 5,061,569, and 4,4',4"-tris(N-(3-methylphenyl)-N-phenylamino)triphenylamine, wherein three triphenylamine units are linked to each other in a star-burst form, disclosed in JP-A-4-308688. Inorganic compounds such as aromatic dimethylidene type compounds, mentioned above as the material for an emitting layer, and p-type Si and p-type SiC can also be used as the material of the hole-injecting layer or the hole-transporting layer.

This hole-injecting layer or the hole-transporting layer may be a single layer made of one or more of the above-mentioned materials. Hole-injecting layers or the hole-transporting layers made of compounds different from each other may be stacked.

The thickness of the hole-injecting layer or the hole-transporting layer is not particularly limited, and is preferably 20 to 200 nm.

The organic semiconductor layer is a layer for helping the injection of holes or electrons into the emitting layer, and is preferably a layer having an electroconductivity of 10⁻¹⁰ S/cm or more. The material of such an organic semiconductor layer may be an electroconductive oligomer, such as thiophene-containing oligomers or arylamine-containing oligomers disclosed in JP-A-8-193191, electroconductive dendrimers such as arylamine-containing dendrimers. The thickness of the organic semiconductor layer is not particularly limited, and is preferably 10 to 1,000 nm.

The organic layer nearest to the anode may contain an oxidant. Preferable oxidants are electron attractors or electron acceptors. Lewis acids, various quinone derivatives, dicyanoquinodimethane derivatives, and salts of aromatic amines and Lewis acids are preferably used. Particularly preferred Lewis acids include iron chloride, antimony chloride and aluminum chloride.

### (2) Second organic layer

An electron-injecting layer, an electron-transporting layer and the like can be arranged between a cathode and an emitting layer as a second organic layer. The electron-injecting layer or the electron-transporting layer is a layer for helping the injection of electrons into the emitting layer, and has a large electron mobility. The electron-injecting layer is formed to control energy level, for example, to reduce rapid energy level changes.

The thickness of electron-transporting layer is properly selected several nm to several µm but preferably selected such that the electron mobility is 10⁻⁵ cm²/Vs or more when applied with an electric field of 10⁴ to 10⁶ V/cm.

The material used for the electron-injecting layer is preferably a metal complex of 8-hydroxyquinoline or a derivative thereof.
Specific examples of the metal complex of 8-hydroxyquinoline or a derivative thereof include metal chelate oxynoid compounds containing a chelate of oxine (generally, 8-quinolinol or 8-hydroxyquinoline).
For example, Alq described above can be used for the electron-injecting layer.

Examples of the oxadiazole derivatives include electron-transporting compounds represented by the following general formulas: 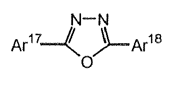 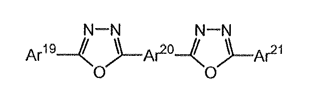 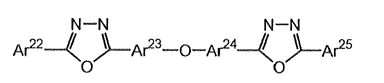 wherein Ar¹⁷, Ar¹⁸, Ar¹⁹, Ar²¹, Ar²² and Ar²⁵ may be the same or different and each represent a substituted or unsubstituted aryl group; and Ar²⁰, Ar²³ and Ar²⁴ may be the same or different and each represent a substituted or unsubstituted arylene group.

Examples of the aryl group include phenyl, biphenyl, anthranyl, perylenyl, and pyrenyl groups. Examples of the arylene group include phenylene, naphthylene, biphenylene, anthranylene, perylenylene, and pyrenylene groups.
Examples of the substituents include alkyl groups with 1 to 10 carbon atoms, alkoxy groups with 1 to 10 carbon atoms, and a cyano group. The electron-transporting compounds are preferably ones from which a thin film can be easily formed.

Specific examples of the electron-transporting compounds are given below.

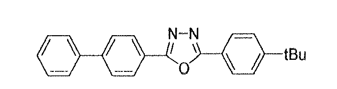

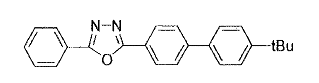

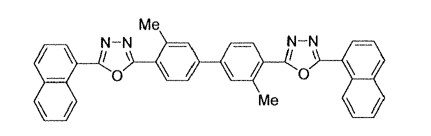

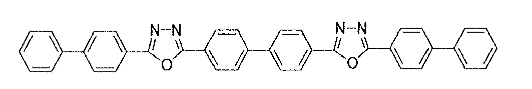

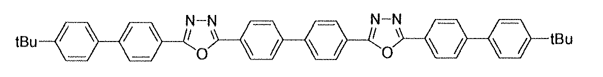

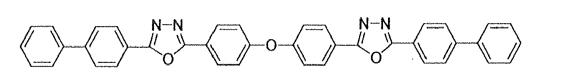

Specific examples of other electron-transporting compounds are given below.
Nitrogen-containing heterocyclic compounds represented by the following formulas 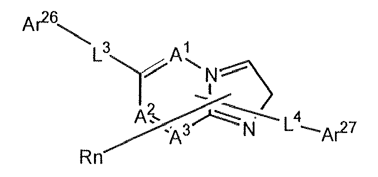 wherein A¹ to A³ is a nitrogen atom or carbon atom;
R is a substituted or unsubstituted aryl group with 6 to 60 carbon atoms, a substituted or unsubstituted heteroaryl group with 3 to 60 carbon atoms, an alkyl group with 1 to 20 carbon atoms, a haloalkyl group with 1 to 20 carbon atoms, or an alkoxy group with 1 to 20 carbon atoms; n is an integer of 0 to 5 and when n is an integer of 2 or more, Rs may be the same or different or adjacent Rs may be bonded to each other to form a substituted or unsubstituted carbocyclic aliphatic ring or a substituted or unsubstituted carbocyclic aromatic ring;
Ar²⁶ is a substituted or unsubstituted aryl group with 6 to 60 carbon atoms, or a substituted or unsubstituted heteroaryl group with 3 to 60 carbon atoms;
Ar²⁷ is a hydrogen atom, an alkyl group with 1 to 20 carbon atoms, a haloalkyl group with 1 to 20 carbon atoms, an alkoxy group with 1 to 20 carbon atoms, a substituted or unsubstituted aryl group with 6 to 60 carbon atoms, or a substituted or unsubstituted heteroaryl group with 3 to 60 carbon atoms;
provided that either one of Ar²⁶and Ar²⁷ is a substituted or unsubstituted condensed cyclic group with 10 to 60 carbon atoms or a substituted or unsubstituted condensed heterocyclic group with 3 to 60 carbon atoms; and
L³ and L⁴ are each a single bond, a substituted or unsubstituted condensed cyclic group with 6 to 60 carbon atoms, a substituted or unsubstituted condensed heterocyclic group with 3 to 60 carbon atoms, or a substituted or unsubstituted fluorenylene group.

Nitrogen-containing heterocyclic compounds represented by the following formula:

HAr-L⁵-Ar²⁸-Ar²⁹

wherein HAr is a substituted or unsubstituted nitrogen-containing heterocyclic ring with 3 to 40 carbon atoms;
L⁵ is a single bond, a substituted or unsubstituted arylene group with 6 to 60 carbon atoms, a substituted or unsubstituted heteroarylene group with 3 to 60 carbon atoms, or a substituted or unsubstituted fluorenylene group;
Ar²⁸ is a substituted or unsubstituted bivalent aromatic hydrocarbon group with 6 to 60 carbon atoms; and
Ar²⁹ is a substituted or unsubstituted aryl group with 6 to 60 carbon atoms or a substituted or unsubstituted heteroaryl group with 3 to 60 carbon atoms.

An EL device using a silacyclopentadiene derivative represented by the following formula, disclosed in JP-A-09-087616: 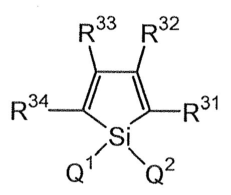 wherein Q¹ and Q² are each a saturated or unsaturated hydrocarbon group with 1 to 6 carbon atoms, an alkoxy group, an alkenyloxy group, an alkynyloxy group, a hydroxyl group, a substituted or unsubstituted aryl group, or a substituted or unsubstituted heterocyclic group, or Q¹ and Q² are bonded to each other to form a saturated or unsaturated ring; and R³¹ to R³⁴ are each a hydrogen atom, a halogen atom, a substituted or unsubstituted alkyl group with 1 to 6 carbon atoms, an alkoxy group, an aryloxy group, a perfluoroalkyl group, a perfluoroalkoxy group, an amino group, an alkylcarbonyl group, an arylcarbonyl group, an alkoxycarbonyl group, an aryloxycarbonyl group, an azo group, an alkylcarbonyloxy group, an arylcarbonyloxy group, an alkoxycarbonyloxy group, an aryloxycarbonyloxy group, a sulfinyl group, a sulfonyl group, a sulfanyl group, a silyl group, a carbamoil group, an aryl group, a heterocyclic group, an alkenyl group, an alkynyl group, a nitro group, a formyl group, a nitroso group, a formyloxy group, an isocyano group, a cyanate group, an isocyanate group, a thiocyanate group, an isothiocyanate group or a cyano group, or adjacent R³¹ to R³⁴ may form a substituted or unsubstituted condensed ring structure.

Silacyclopentadiene derivatives represented by the following formula, disclosed in JP-A-09-194487: 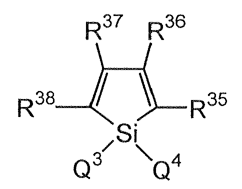 wherein Q³ and Q⁴ are each a saturated or unsaturated hydrocarbon group with 1 to 6 carbon atoms, an alkoxy group, an alkenyloxy group, an alkynyloxy group, a substituted or unsubstituted aryl group, or a substituted or unsubstituted heterocyclic group, or Q³ and Q⁴ are bonded to each other to form a saturated or unsaturated ring structure; and R³⁵ to R³⁸ are each a hydrogen atom, a halogen atom, a substituted or unsubstituted alkyl group with 1 to 6 carbon atoms, an alkoxy group, an aryloxy group, a perfluoroalkyl group, a perfluoroalkoxy group, an amino group, an alkylcarbonyl group, an arylcarbonyl group, an alkoxycarbonyl group, an aryloxycarbonyl group, an azo group, an alkylcarbonyloxy group, an arylcarbonyloxy group, an alkoxycarbonyloxy group, an aryloxycarbonyloxy group, a sulfinyl group, a sulfonyl group, a sulfanyl group, a silyl group, a carbamoil group, an aryl group, a heterocyclic group, an alkenyl group, an alkynyl group, a nitro group, a formyl group, a nitroso group, a formyloxy group, an isocyano group, a cyanate group, an isocyanate group, a thiocyanate group, an isothiocyanate group or a cyano group, or adjacent R³⁵ to R³⁸ may bond to form a structure
wherein substituted or unsubstituted rings are condensed to each other;
provided that in the case where R³⁵ and R³⁸ are a phenyl group, Q³ and Q⁴ are neither an alkyl group nor a phenyl group; in the case where R⁵ and R³⁸ are a thienyl group, Q³, Q⁴, R³⁶ and R³⁷ do not form the structure where Q³ and Q⁴ are a monovalent hydrocarbon group, and R³⁶ and R³⁷ are an alkyl group, an aryl group, an alkenyl, or R³⁶ and R³⁷ bond to form an aliphatic group with a ring; in the case where R³⁵ and R³⁸ are a silyl group, R³⁶, R³⁷, Q³ and Q⁴ are each neither a monovalent hydrocarbon group with 1 to 6 carbon atoms nor a hydrogen atom; and in the case where R³⁵ and R³⁶ form a condensed benzene ring, Q³ and Q⁴ are neither an alkyl group nor a phenyl group.

Borane derivatives represented by the following formula, disclosed in JP-A1-2000-040586: 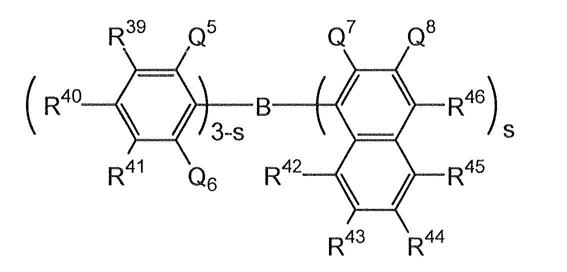 wherein R³⁹ to R⁴⁶ and Q⁸ are each a hydrogen atom, a saturated or unsaturated hydrocarbon group, an aromatic group, a heterocyclic group, a substituted amino group, a substituted boryl group, an alkoxy group or an aryloxy group; Q⁵, Q⁶ and Q⁷ are each a saturated or unsaturated hydrocarbon group, an aromatic group, a heterocyclic group, a substituted amino group, an alkoxy group or an aryloxy group; the substituents of Q⁷ and Q⁸ may be bonded to each other to form a condensed ring; s is an integer of 1 to 3, and Q⁷s may be different from each other when s is 2 or more; provided that excluded are the compounds where s is 1, Q⁵, Q⁶ and R⁴⁰ are methyl groups and R⁴⁶ is a hydrogen atom or substituted boryl group, and the compounds where s is 3 and Q⁷ is a methyl group.

Compounds represented by the following formula, disclosed in JP-P-10-088121: 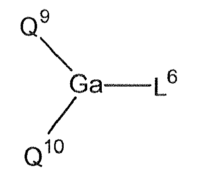 wherein Q⁹ and Q¹⁰ are independently a ligand represented by the following formula (3); and L⁶ is a halogen atom, a substituted or unsubstituted alkyl group, a substituted or unsubstituted cycloalkyl group, a substituted or unsubstituted aryl group, a substituted or unsubstituted heterocyclic group, or a ligand represented by -OR⁴⁷ (R⁴⁷ is a hydrogen atom, a substituted or unsubstituted alkyl group, a substituted or unsubstituted cycloalkyl group, a substituted or unsubstituted aryl group, or a substituted or unsubstituted heterocyclic group), or -O-Ga-Q¹¹(Q¹²) (Q¹¹ and Q¹² are the same as Q⁹ and Q¹⁰.

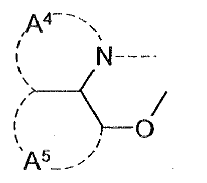

wherein rings A⁴ and A⁵ are each a substituted or unsubstituted 6-membered aryl rings which are condensed to each other.
The metal complexes have the strong nature of an n-type semiconductor and large ability of injecting electrons. Further the energy generated at the time of forming such a complex is small and therefore strong bonding can be obtained between a metal and ligands in the complex formed, and a fluorescent quantum efficiency is large as an emitting material.

Specific examples of substituents of the rings A⁴ and A⁵ which form the ligands of the above formula include halogen atoms such as chlorine, bromine, iodine and fluorine; substituted or unsubstituted alkyl groups such as methyl, ethyl, propyl, butyl, sec-butyl, tert-butyl, pentyl, hexyl, heptyl, octyl, stearyl and trichloromethyl; substituted or unsubstituted aryl groups such as phenyl, naphthyl, 3-methylphenyl, 3-methoxyphenyl, 3-fluorophenyl, 3-trichloromethylphenyl, 3-trifluoromethylphenyl and 3-nitrophenyl; substituted or unsubstituted alkoxy groups such as methoxy, n-butoxy, tert-butoxy, trichloromethoxy, trifluoroethoxy, pentafluoropropoxy, 2,2,3,3-tetrafluoropropoxy, 1,1,1,3,3,3-hexafluoro-2-propoxy and 6-(perfluoroethyl)hexyloxy; substituted or unsubstituted aryloxy groups such as phenoxy, p-nitrophenoxy, p-tert-butylphenoxy, 3-fluorophenoxy, pentafluorophenyl and 3-trifluoromethylphenoxy; substituted or unsubstituted alkylthio groups such as methythio, ethylthio, tert-butylthio, hexylthio, octylthio and trifruoromethyltio; substituted or unsubstituted arylthio groups such as phenylthio, p-nitrophenylthio, p-tert-butylphenylthio, 3-fluorophenylthio, pentafluorophenylthio and 3-trifluoromethylphenylthio; a cyano group; a nitro group, an amino group; mono or di-substituted amino groups such as amino, methylamino, diethylamino, ethylamino, diethylamino, dipropylamino, dibutylamino and diphenylamino; acylamino groups such as bis(acetoxymethyl)amino, bis(acetoxyethyl)amino, bis(acetoxypropyl)amino and bis(acetoxybutyl)amino; a hydroxy group; a siloxy group; an acyl group; a carbamoyl group; substituted carbamoyl groups such as methylcarbamoyl, dimethylcarbamoyl, ethylcarbamoyl, diethylcarbamoyl, propylcarbamoyl, butylcarbamoyl and phenylcarbamoyl; a carboxylic group; a sulfonic acid group; an imido group; cycloalkyl groups such as cyclopentane and cyclohexyl; aryl groups such as phenyl, naphthyl, biphenyl, anthranyl, phenanthryl, fluorenyl and pyrenyl; and heterocyclic groups such as pyridinyl, pyrazinyl, pyrimidinyl, pryidazinyl, triazinyl, indolinyl, quinolinyl, acridinyl, pyrrolidinyl, dioxanyl, piperidinyl, morpholidinyl, piperazinyl, triathinyl, carbazolyl, furanyl, thiophenyl, oxazolyl, oxadiazolyl, benzooxazolyl, thiazolyl, thiadiazolyl, benzothiazolyl, triazolyl, imidazolyl, benzoimidazolyl and puranyl. Moreover the above-mentioned substituents may be bonded to each other to form a six-membered aryl or heterocyclic ring.

A reducing dopant may be contained in an electron-transporting region or in an interfacial region between a cathode and an organic layer. The reducing dopant is defined as a substance which can reduce an electron-transporting compound. Accordingly, various substances with certain reducing properties can be used. For example, at least one substance can be preferably used which is selected from the group consisting of alkali metals, alkaline earth metals, rare earth metals, alkali metal oxides, alkali metal halides, alkaline earth metal oxides, alkaline earth metal halides, rare earth metal oxides, rare earth metal halides, alkali metal organic complexes, alkaline earth metal organic complexes, and rare earth metal organic complexes.

Specific examples of preferred reducing dopants include at least one alkali metal selected from the group consisting of Na (work function: 2.36 eV), K (work function: 2.28 eV), Rb (work function: 2.16 eV) and Cs (work function: 1.95 eV) or at least one alkaline earth metal selected from the group consisting of Ca (work function: 2.9 eV), Sr (work function: 2.0 to 2.5 eV) and Ba (work function: 2.52 eV). Particularly preferred are ones having a work function of 2.9 eV or less. Among these, a more preferable reducing dopant is at least one alkali metal selected from the group consisting of K, Rb and Cs, even more preferably Rb and Cs and the most preferably Cs. These alkali metals have a particularly high reducing ability, and therefore adding a relatively small amount thereof into an electron-injecting region enhances the luminance and lifetime of the organic EL device. As a reducing dopant having a work function of 2.9 eV or less, combinations of two or more of these alkali metals are preferable. Combinations with Cs, for example, Cs and Na, Cs and K, Cs and Rb, or Cs, Na and K are particularly preferable. The combination with Cs efficiently exhibits a reducing ability and the addition thereof into an electron-injecting region enhances the luminance and the lifetime of the organic EL device.

In the invention, an electron-injecting layer which is formed of an insulator or a semiconductor may be further provided between a cathode and an organic layer. By providing the layer, current leakage can be effectively prevented to improve the injection of electrons. As the insulator, at least one metal compound selected from the group consisting of alkali metal calcogenides, alkaline earth metal calcogenides, halides of alkali metals and halides of alkaline earth metals can be preferably used. When the electron-injecting layer is formed of the alkali metal calcogenide or the like, the injection of electrons can be preferably further improved. Specifically preferable alkali metal calcogenides include Li₂O, LiO, Na₂S, Na₂Se and NaO and preferable alkaline earth metal calcogenides include CaO, BaO, SrO, BeO, BaS and CaSe. Preferable halides of alkali metals include LiF, NaF, KF, LiCl, KCl and NaCl. Preferable halides of alkaline earth metals include fluorides such as CaF₂, BaF₂, SrF₂, MgF₂ and BeF₂ and halides other than fluorides.

Examples of the semiconductor for forming an electron-transporting layer include oxides, nitrides or oxynitrides containing at least one element selected from Ba, Ca, Sr, Yb, Al, Ga, In, Li, Na, Cd, Mg, Si, Ta, Sb and Zn, and combinations of two or more thereof. The inorganic compound for an electron-transporting layer is preferably a microcrystalline or amorphous insulating thin film. When an electron-transporting layer is formed of the insulating thin film, a more uniform thin film can be formed to reduce pixel defects such as dark spots. Examples of such an inorganic compound include the above-mentioned alkali metal calcogenides, alkaline earth metal calcogenides, halides of alkali metals, and halides of alkaline earth metals.
The thickness of electron-injecting or electron-transporting layer is not particularly limited but preferably 1 to 100 nm.

The organic layer nearest the cathode may contain a reducing agent. Preferable reducing agents are alkali metals, alkaline earth metals, oxides of alkali metals, oxides of alkaline earth metals, oxides of rare earth metals, halides of alkali metals, halides of alkaline earth metals, halides of rare earth metals, and complexes formed of alkali metals and aromatic compounds. Particularly preferred alkali metals are Cs, Li, Na and K.

### (3) Inorganic compound layer

There may be provided an inorganic compound layer(s) in contact with an anode and/or a cathode. The inorganic compound layer functions as an adhesion improving layer. Preferable inorganic compounds used for the inorganic compound layer include alkali metal oxides, alkaline earth metal oxides, rare earth metal oxides, alkali metal halides, alkaline earth metal halides, rare earth metal halides, and various oxides, nitrides and nitric oxides such as a silicon oxide, aluminum oxide, germanium oxide, lithium oxide, titanium oxide, tantalum oxide, silicon nitride, tantalum nitride, SiON, AlON, LiON, TiON, TaON, and C. As a component of the layer in contact with the anode, silicon oxide, aluminum oxide, silicon nitride, germanium oxide, SiON, AlON and C are preferable, since they can form a stable injecting interface layer. As a component of the layer in contact with the cathode, LiF, MgF₂, CaF₂, MgF₂ and NaF are preferable. The thickness of the inorganic compound layer is not particularly limited, and is preferably 0.1 nm to 100 nm.

Another organic layer or inorganic layer may be interposed between the anode and the blue emitting layer or between the yellow-to-orange or red emitting layer and the cathode. The interposing layer is not limited so long as it can transport electrons and holes, and it is transparent. Preferred examples include In oxides, Sn oxides, Zn oxides, Zn sulfides, Cd sulfides, Ga nitrides and mixtures thereof.

Methods of forming respective organic layers including an emitting layer and inorganic compound layers are not particularly limited. For example, known methods such as deposition, spin coating, casting, and LB technique can be applied. The electron-injecting layer and the emitting layer are preferably formed by the same method, because this makes the properties of the organic EL devices obtained constant and the production time can be shortened. For example, when the electron-injecting layer is formed by deposition, the emitting layer is preferably also formed by deposition.

### (4) Electrodes

For the anode, the following is preferably used: metals, alloys, electric conductive compounds, or mixtures thereof that have a large work function (e.g., 4 eV or more). Specific examples include indium tin oxide (ITO), indium zinc oxide, tin, zinc oxide, gold, platinum, and palladium. They can be used individually or as a combination of 2 or more kinds.
The thickness of the anode is not particularly limited, but is preferably 10 to 1,000 nm, more preferably 10 to 200 nm.

For the cathode, the following is preferably used: metals, alloys, electric conductive compounds, or mixtures thereof that have a small work function (e.g., less than 4 eV). Specific examples include magnesium, aluminum, indium, lithium, sodium, and silver. They can be used individually or as a combination of 2 or more kinds. The thickness of the cathode is not also particularly limited, but is preferably 10 to 1,000 nm, more preferably 10 to 200 nm. It is preferred that at least one of the anode and the cathode be substantially transparent, more specifically, have a light transmission of 10% or more, in order to effectively outcouple light emitted from an emitting layer to the outside.

The electrodes can be formed by vacuum deposition, sputtering, ion plating, electron beam deposition, CVD, MOCVD, plasma CVD and so on.

### [Examples]

The invention will be explained with reference to Examples. The invention shall not be limited to these.
The organic EL device obtained in each Example was measured for an initial performance by the following methods.
(1) Chromaticity
   A predetermined voltage was applied to a device, and CIE1931 chromaticity coordinates were measured.
(2) Luminous efficiency
   Applying a predetermined voltage to a device, a luminance was measured with CS-100 supplied by MINOLTA Co., Ltd. and a current was simultaneously measured with an ampere meter supplied by Keithley Instruments Inc. A luminous efficiency was calculated from the measurement values thereof.

### Example 1

A 25 mm x 75 mm and 1.1 mm thick glass substrate with an ITO transparent electrode (anode) (supplied by GEOMATEC CO., LTD.) was subjected to ultrasonic cleaning in isopropyl alcohol for 5 minutes and then subjected to UV ozone cleaning for 30 minutes.
The cleaned glass substrate with transparent electrode lines was fitted to a substrate holder of a vacuum vapor deposition apparatus. First, a 60 nm thick film of N,N'-bis(N,N'-diphenyl-4-aminophenyl)-N,N-diphenyl-4,4'-diamino-1,1'-biphenyl (to be abbreviated as "TPD232 film" hereinafter) was formed on the surface thereof on which the transparent electrode lines were formed so as to cover the above transparent electrode. The TPD 232 film functioned as a hole-injecting layer.
The formation of the TPD232 film was followed by formation of a 20 nm thick film of 4,4'-bis[N-(1-naphthyl)-N-phenylamino]biphenyl (to be abbreviated as "NPD film" hereinafter) on the TPD232 film. The NPD film functioned as a hole-transporting layer.

Further, the formation of the NPD film was followed by formation of a 10 nm thick film, which was formed by vapor deposition of a styryl derivative DPVDPAN of the formula [29] as a host and B1 of the formula [30] as a dopant at a weight ratio of 40:1, to obtain a first emitting layer. This first emitting layer emitted light in blue.
Then, a 40 nm thick film was formed by depositing CBP of the formula [31] as a host and an iridium complex of the formula [32] as a dopant at a weight ratio of 30:1.5 to obtain a second emitting layer. This second emitting layer emitted light in red.

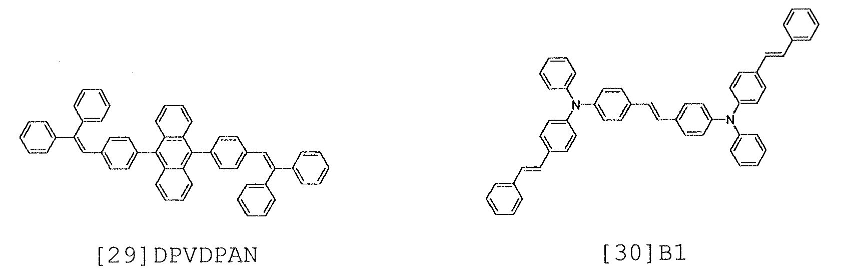

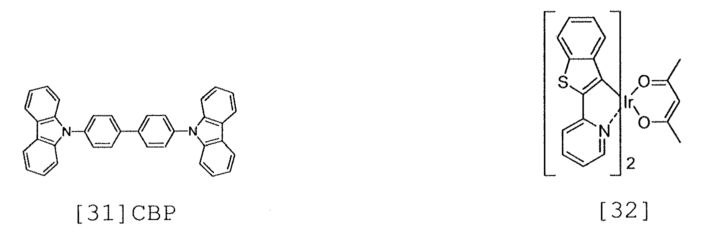

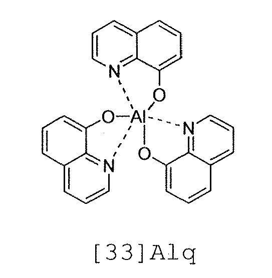

A 10 nm thick tris(8-quinolinol)aluminum film (Alq film, formula [33]) was formed thereon as an electron-transporting layer. Thereafter lithium (lithium source: Saes getter Co., Ltd.) and Alq were co-deposited to form a 10 nm thick Alq:Li film as an electron-injecting layer. Metal Al was deposited on this Alq:Li film in a thickness of 150 nm to form a metallic cathode, thereby forming an organic EL device.

The above device had a luminance of 95 cd/m² and an efficiency of 14 cd/A at a DC voltage of 8.5 V as an initial performance. Light from the device has CIE1931 chromaticity coordinates of (x,y) = (0.281, 0.282) and was white.
Table 1 shows measurement results of initial luminance and chromaticity of organic EL devices obtained in Example 1 and the following Examples 2 to 3 and Comparative Example 1.

**Table 1**

| | Initial chromaticity (x,y) | Luminous efficiency (cd/A) |
|---|---|---|
| Example 1 | (0.281,0.282) | 14 |
| Example 2 | (0.293,0.282) | 13 |
| Example 3 | (0.292,0.280) | 16 |
| Example 4 | (0.290,0.280) | 15 |
| Comparative Example 1 | (0.282, 0.281) | 7 |

### Example 2

A device was fabricated by the same method as in Example 1 except that a compound represented by formula [34] was used instead of CBP.
The above device had a luminance of 100 cd/m² and an efficiency of 13 cd/A at a DC voltage of 7.5 V as an initial performance. Light from the device has CIE1931 chromaticity coordinates of (x,y) = (0.293, 0.282) and was white.

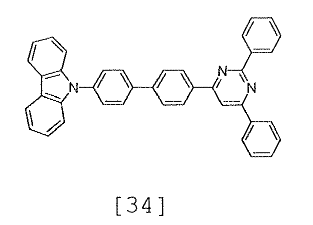

### Example 3

A device was fabricated by the same method as in Example 1 except that a compound represented by formula [35] as a host compound and a compound represented by formula [36] as a dopant compound were used instead of formulas [31] and [32].
The above device had a luminance of 100 cd/m² and an efficiency of 16 cd/A at a DC voltage of 7.3 V. Light from the device has CIE1931 chromaticity coordinates of (x,y) = (0.292, 0.280) and was white.

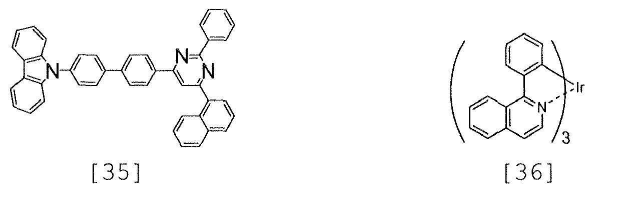

### Example 4

A 25 mm x 75 mm and 1.1 mm thick glass substrate with an ITO transparent electrode (anode) (supplied by GEOMATEC CO., LTD.) was subjected to ultrasonic cleaning in isopropyl alcohol for 5 minutes and then subjected to UV ozone cleaning for 30 minutes.
The cleaned glass substrate with transparent electrode lines was fitted to a substrate holder of a vacuum vapor deposition apparatus. First, a 60 nm thick film of TPD232 was formed on the surface thereof on which the transparent electrode lines were formed so as to cover the above transparent electrode. The TPD 232 film functioned as a hole-injecting layer.
The formation of the TPD232 film was followed by formation of a 20 nm thick film of NPD on the TPD232 film. The NPD film functioned as a hole-transporting layer.

Further, the formation of the NPD film was followed by formation of a 30 nm thick film, which was formed by vapor deposition of a compound represented by formula [37] as a host and an iridium complex of the formula [38] as a dopant at a weight ratio of 40:3, to obtain a second emitting layer. This second emitting layer emitted light in blue.
Then, a 30 nm thick film was formed by depositing a styryl derivative DPVDPAN as a host and R1 of the formula [39] (fluorescence peak wavelength: 545 nm) as a dopant at a weight ratio of 40:1 to obtain a first emitting layer. This first emitting layer emitted light in yellow to red.

A 10 nm thick Alq film was formed thereon as an electron-transporting layer. Thereafter Li (Li source: Saes getter Co., Ltd.) and Alq were co-deposited to form a 10 nm thick Alq:Li film as an electron-injecting layer. Metal Al was deposited on this Alq:Li film in a thickness of 150 nm to form a metallic cathode, thereby forming an organic EL device.

The above device had a luminance of 100 cd/m² and an efficiency of 15 cd/A at a DC voltage of 7.6 V as an initial performance. Light from the device has CIE1931 chromaticity coordinates of (x,y) = (0.290, 0.280) and was white.

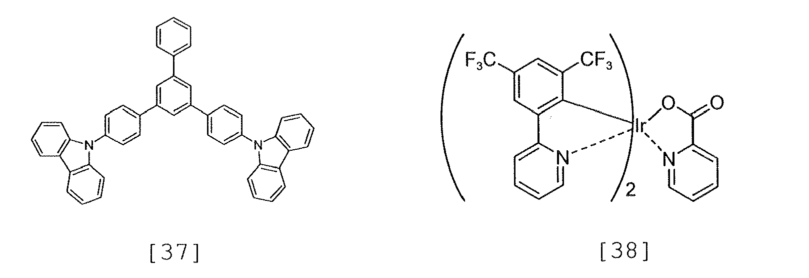

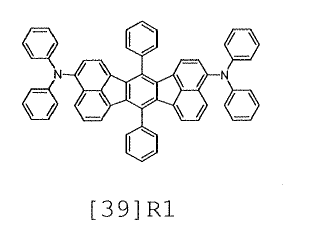

### Comparative example 1

A 25 mm x 75 mm and 1.1 mm thick glass substrate with an ITO transparent electrode (anode) (supplied by GEOMATEC CO., LTD.) was subjected to ultrasonic cleaning in isopropyl alcohol for 5 minutes and then subjected to UV ozone cleaning for 30 minutes.
The cleaned glass substrate with transparent electrode lines was fitted to a substrate holder of a vacuum vapor deposition apparatus. First, a 60 nm thick film of TPD232 was formed on the surface thereof on which the transparent electrode lines were formed so as to cover the above transparent electrode. The TPD 232 film functioned as a hole-injecting layer.
The formation of the TPD232 film was followed by formation of a 20 nm thick film of NPD on the TPD232 film. The NPD film functioned as a hole-transporting layer.

Further, the formation of the NPD film was followed by formation of a 10 nm thick film, which was formed by vapor deposition of a styryl derivative DPVDPAN of the formula [29] and B1 of the formula [30] at a weight ratio of 40:1, to obtain a blue emitting layer.
Then, a 30 nm thick film was formed by depositing the styryl derivative DPVDPAN and R1 of the formula [39] (fluorescence peak wavelength: 545 nm) at a weight ratio of 40:1 to obtain a yellow-to-red emitting layer.
As described above, a fluorescent dopant was used in both emitting layers in this example.

A 10 nm thick Alq film was formed thereon as an electron-transporting layer. Thereafter Li (Li source: Saes getter Co., Ltd.) and Alq were co-deposited to form a 10 nm thick Alq:Li film as an electron-injecting layer. Metal Al was deposited on this Alq:Li film in a thickness of 150 nm to form a metallic cathode, thereby forming an organic EL device.

The above device had a luminance of 99 cd/m² and an efficiency of 7 cd/A at a DC voltage of 8.3 V as an initial performance. Light from the device has CIE1931 chromaticity coordinates of (x,y) = (0.282, 0.281) and was white.

From the results shown in Table 1, it was confirmed that both two emitting layers could be emitted efficiently in the organic EL device of the invention, whereby the device was more excellent in luminance than that of Comparative Example 1.

### Industrial Applicability

The organic EL device of the invention can be suitably applied to displays such as information displays, automobile displays etc., illumination and the like.

## Claims

1. An organic electroluminescent device comprising; at least an anode, an organic emitting layer and a cathode stacked in this order;
at least a first emitting layer comprising a fluorescent dopant and a second emitting layer comprising a phosphorescent dopant being stacked in the organic emitting layer.

2. The organic electroluminescence device according to claim 1, wherein the first emitting layer is closer to the anode than the second emitting layer.

3. The organic electroluminescent device according to claim 1, wherein the first emitting layer is closer to the cathode than the second emitting layer.

4. The organic electroluminescent device according to claim 1, wherein a host of the first emitting layer comprises an electron transporting compound or hole transporting compound, and a host of the second emitting layer comprises an electron transporting compound or hole transporting compound.

5. The organic electroluminescent device according to claim 4, wherein the electron mobility of the electron transporting compound is 10⁻⁵ cm²/V·s or more.

6. The organic electroluminescent device according to claim 4, wherein the hole mobility of the hole transporting compound is 10⁻⁴ cm²/V·s or more.

7. The organic electroluminescent device according to any one of claims 1 to 6, wherein the first emitting layer emits blue light, or yellow-to-orange or red light.

8. The organic electroluminescent device according to any one of claims 1 to 6, wherein the second emitting layer emits blue light, or yellow-to-orange or red light.

9. The organic electroluminescent device according to any one of claims 1 to 6 which emits white light.

10. A display comprising the organic electroluminescent device according to any one of claims 1 to 6.
